# EUROPEAN PATENT SPECIFICATION

(11) **EP 4 642 184 B1**
(45) Date of publication and mention of the grant of the patent: **13.05.2026**
(21) Application number: 25159843.9
(22) Date of filing: 25.02.2025
(51) Int. Cl.: H10B 12/00, H10D 64/01

(54) **SEMICONDUCTOR DEVICES**
HALBLEITERANORDNUNGEN
DISPOSITIFS SEMI-CONDUCTEURS

(30) Priority: 23.04.2024 KR 20240053974
(43) Date of publication of application: 29.10.2025
(73) Proprietor: Samsung Electronics Co., Ltd., Suwon-si, Gyeonggi-do 16677 (KR)
(72) Inventor: KIM, Junsoo, 16677 Suwon-si, Gyeonggi-do (KR); OH, Jeonghoon, 16677 Suwon-si, Gyeonggi-do (KR); JANG, Sungho, 16677 Suwon-si, Gyeonggi-do (KR)
(74) Representative: Kuhnen & Wacker Patent- und Rechtsanwaltsbüro PartG mbB

(56) References cited:
- US-A1- 2005 247 982
- US-A1- 2020 220 024
- US-A1- 2023 055 499

## Description

### BACKGROUND

The present disclosure relates to semiconductor devices, and more particularly to semiconductor devices including a vertical channel transistor.

As demand for high performance, high speed, and/or multifunctionality of semiconductor devices increases, the degree of integration of a semiconductor device has increased. In manufacturing fine-patterned semiconductor devices in response to the trend for high integration of semiconductor devices, it may be required to implement patterns having a fine width or a fine separation distance.
US 2023/055499 discloses a DRAM memory device with vertical channels of the access transistors. US 2005/247982 discloses a planar DRAM device having access transistors with charge trapping regions.

### SUMMARY

An aspect of the present disclosure is to provide a semiconductor device including a vertical channel transistor configured to increase integration density.

However, objects of the present disclosure are not limited to the above-described objects, and may be variously extended.

The invention is set out in the appended claims.

The at least one charge trapping layer may function as a back gate capable of controlling charges accumulated in a vertical channel region of an active pattern. For example, the vertical channel region within the active pattern may be a floating body disposed between an upper source/drain region and a lower source/drain region, and the at least one charge trapping layer may suppress or prevent the performance of a transistor from being degraded due to a floating body effect. For example, the at least one charge trapping layer may minimize or prevent a change in a threshold voltage of the transistor by accumulating charges, i.e., holes, within the floating body in the vertical channel region.

Advantages and effects of the embodiments disclosed herein are not limited to the foregoing content and may be variously extended.

### BRIEF DESCRIPTION OF THE DRAWINGS

The above and other aspects, features, and advantages of the present disclosure will be more clearly understood from the following detailed description, taken in conjunction with the accompanying drawings, in which:
FIG. 1 is a schematic perspective view of a semiconductor device according to an example embodiment of the present disclosure;
FIG. 2 is a plan view of a semiconductor device according to an example embodiment of the present disclosure;
FIG. 3 is a cross-sectional view taken along line I-I' of the semiconductor device illustrated in FIG. 2 according to an example embodiment;
FIG. 4A is an enlarged view of region A of the semiconductor device of FIG. 3 according to an example embodiment;
FIG. 4B is an enlarged view of region A of the semiconductor device of FIG. 3 according to another example embodiment;
FIG. 4C is an enlarged view of region A of the semiconductor device of FIG. 3 according to another example embodiment;
FIG. 5A is a view illustrating an operation of trapping a charge in a charge trapping layer of a charge trapping structure of the semiconductor device of FIG. 4A;
FIG. 5B is a diagram illustrating an operation of trapping a charge in a charge trapping layer of a charge trapping structure of the semiconductor device of FIG. 4C; and
FIGS. 6A to 6I are diagrams illustrating an example embodiment of a method of manufacturing a semiconductor device.

### DETAILED DESCRIPTION

Hereinafter, example embodiments of the present disclosure will be described in more detail with reference to the attached drawings. The same reference numerals are used for the same components in the drawings, and duplicate descriptions for the same components are omitted. As used herein, the term "and/or" includes any and all combinations of one or more of the associated listed items. It will be understood that when an element is referred to as being "on," "attached" to, "connected" to, "coupled" with, "contacting," etc., another element, it can be directly on, attached to, connected to, coupled with or contacting the other element or intervening elements may also be present. In contrast, when an element is referred to as being, for example, "directly on," "directly attached" to, "directly connected" to, "directly coupled" with or "directly contacting" another element, there are no intervening elements present. In embodiments of the inventive concept, a singular form of the constituent components may include a plural form unless the context clearly indicates otherwise. In the present specification, the drawings are exaggerated for clarifying embodiments of the inventive concept. It is noted that aspects described with respect to one embodiment may be incorporated in different embodiments although not specifically described relative thereto. That is, all embodiments and/or features of any embodiments can be combined in any way and/or combination.

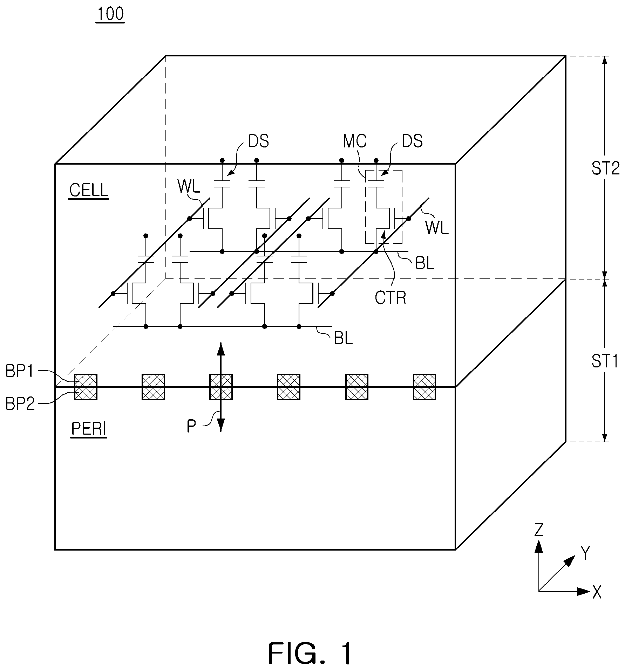

FIG. 1 is a schematic perspective view of a semiconductor device according to an example embodiment of the present disclosure.

Referring to FIG. 1, a semiconductor device 100 may include a first structure ST1 and a second structure ST2 on the first structure ST1. The first structure ST1 may include a peripheral circuit region PERI. The second structure ST2 may include a memory cell array region CELL. The first structure ST1 may overlap the second structure ST2 in a vertical direction (Z-direction).

The memory cell array region CELL may include a memory cell array. In an example, the memory cell array may include bit lines BL, word lines WL, and memory cells MC.

The memory cells MC may include respective cell transistors CTR and information storage elements DS. One memory cell MC may be disposed between one word line WL and one bit line BL. The memory cell array of the semiconductor device 100 may correspond to a memory cell array of a Dynamic Random Access Memory (DRAM) device.

A cell transistor CTR may include a gate and a source/drain. The gate may be connected to the word line WL, the source may be connected to the bit line BL, and the drain may be connected to the information storage element DS. The information storage element DS may include a capacitor formed of lower and upper electrodes and a dielectric layer.

The word lines WL may extend in a second direction (Y-direction) and may be spaced apart from each other in a first direction (X-direction). The word lines WL may be disposed on the same level in the vertical direction (Z-direction) as each other, each of which may be connected to different memory cells MC. The bit lines BL may extend in the first direction (X-direction), and may be spaced apart from each other in the second direction (Y-direction).

The peripheral circuit region PERI may be electrically connected to the memory cell array region CELL. The peripheral circuit region PERI may include peripheral circuit elements. For example, the peripheral circuit region PERI may include sub-word line drivers electrically connected to the word lines WL, and sense amplifiers electrically connected to the bit lines BL.

The first structure ST1 may be bonded to the second structure ST2. For example, first bonding pads BP1 may be included on a lower surface of the second structure ST2, and second bonding pads BP2 may be included on an upper surface of the first structure ST1. The first bonding pads BP1 may be bonded to the second bonding pads BP2 and may electrically connect the first structure ST1 and the second structure ST2. For example, the first bonding pads BP1 and the second bonding pads BP2 may provide a path P electrically connecting the memory cell array region CELL and the peripheral circuit region PERI.

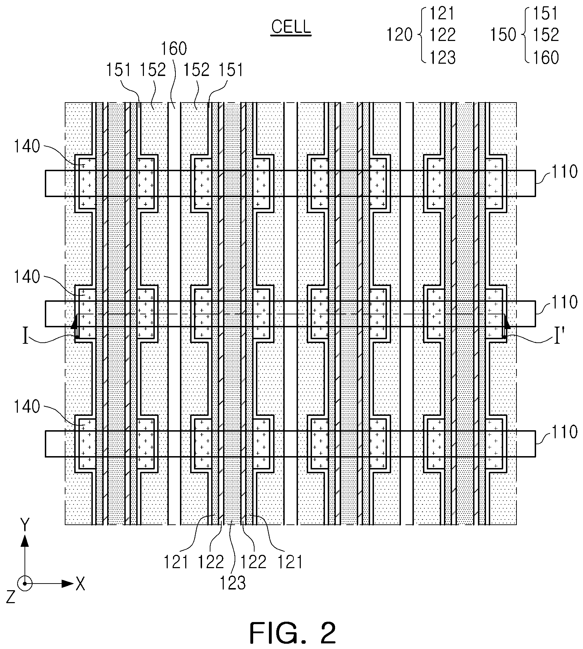

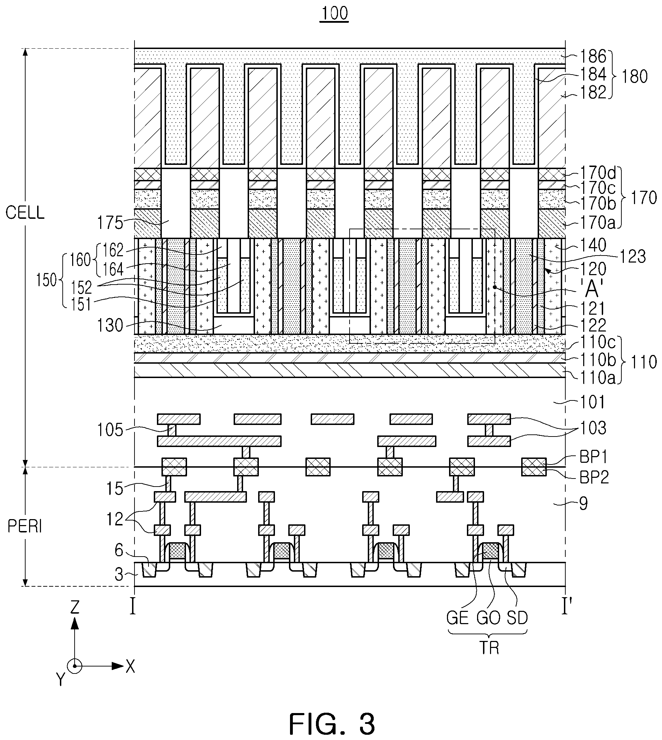

FIG. 2 is a plan view of a semiconductor device according to an example embodiment of the present disclosure. FIG. 3 is a cross-sectional view taken along line I-I' of the semiconductor device illustrated in FIG. 2 according to an example embodiment. According to an example embodiment of the present disclosure, the memory cell array circuit diagram of FIG. 1 may be implemented with the semiconductor device described in FIGS. 2 and 3.

Referring to FIGS. 2 and 3, the memory cell array region CELL of the semiconductor device 100 includes a bit line structure 110, charge trapping structures 120, active patterns 140, word line structures 150, contact patterns 170, and an information storage structure 180.

The bit line structure 110 may extend in the first direction (X-direction). In an example, the bit line structure 110 may be electrically connected to the active patterns 140. The bit line structure 110 may be provided in plural, and a plurality of bit line structures 110 may be spaced apart from each other in the second direction (Y-direction) and may extend in parallel. The bit line structure 110 may correspond to the bit line BL in the circuit diagram illustrated in FIG. 1.

The bit line structure 110 may include doped polysilicon, a metal, conductive metal nitride, a metal-semiconductor compound, conductive metal oxide, conductive graphene, carbon nanotubes, or combinations thereof. For example, at least one of the bit line structures 110 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, graphene, carbon nanotubes, or combinations thereof. In an example, the bit line structure 110 may include a first conductive pattern 110a, a second conductive pattern 110b, and a third conductive pattern 110c, which are sequentially stacked in the vertical direction (Z-direction). The first conductive pattern 110a may include, for example, a metallic material such as titanium (Ti), tantalum (Ta), tungsten (W), and/or aluminum (Al), the second conductive pattern 110b may include, for example, a metal nitride, such as titanium nitride (TiN) or a silicide material such as titanium silicide (TiSi), and the third conductive pattern 110c may include a semiconductor material, such as polycrystalline silicon. The third conductive pattern 110c may be a layer doped with impurities. However, according to example embodiments, the material of layers included in the bit line structure 110, the number of layers, and the thickness thereof may vary.

The word line structures 150 may be disposed on the bit line structure 110. The word line structures 150 are arranged alternately with the charge trapping structures 120 in the first direction (X-direction). The word line structures 150 may be disposed between two adjacent charge trapping structures 120 on the bit line structure 110, and may extend between the active patterns 140.

Each of the word line structures 150 may include a gate dielectric layer 151, word lines 152, and gate capping patterns 160.

The word lines 152 may be disposed between the two adjacent charge trapping structures 120. The word lines 152 may be spaced apart from each other in the first direction (X-direction) and may extend in the second direction (Y-direction). The word lines 152 may include doped polysilicon, a metal, conductive metal nitride, a metal-semiconductor compound, conductive metal oxide, conductive graphene, carbon nanotubes, or combinations thereof. For example, the word line 152 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, graphene, carbon nanotubes, or combinations thereof, but embodiments of the present disclosure are not limited thereto. The word line 152 may include a single layer or multiple layers of the materials described above. Each of the word lines 152 may correspond to one word line WL in the circuit diagram illustrated in FIG. 1.

The gate capping patterns 160 may extend between the word lines 152 in the second direction (Y-direction). The gate capping patterns 160 may include first gate capping patterns 162 disposed on the word lines 152, and a second gate capping pattern 164 extending in the vertical direction (Z-direction) from a space between the word lines 152 to a space between the first gate capping patterns 162. The first gate capping patterns 162 may overlap the word lines 152 in the vertical direction (Z-direction), and may be in contact with the word lines 152. A lower surface of the second gate capping pattern 164 may be disposed between the word lines 152 and may be in contact with an upper surface of the gate dielectric layer 151.

The gate capping pattern 160 may include silicon oxide, silicon nitride, silicon oxynitride, silicon carbonitride, low-κ dielectric, or combinations thereof. For example, the first gate capping patterns 162 may include silicon nitride, and the second gate capping pattern 164 may include silicon oxide. In some example embodiments, the first gate capping patterns 162 and the second gate capping patterns 164 may include the same material, and may be formed integrally.

The gate dielectric layer 151 may be disposed between the active patterns 140 and the first gate capping patterns 162 and between the active patterns 140 and the word lines 152. The gate dielectric layer 151 may extend from a space between the active patterns 140 and the word lines 152 to a space between the insulating pattern 130 and the word lines 152. The gate dielectric layer 151 may have a U-shape in cross-sectional view. For example, the gate dielectric layer 151 may at least partially surround the word lines 152 and the gate capping pattern 160.

The gate dielectric layer 151 may be a tunnel dielectric layer that does not include an information storage layer. For example, each of the gate dielectric layers 151 may include silicon oxide and/or a high-κ dielectric material. The high-κ dielectric material may include metal oxide or metal oxynitride. For example, the high-κ dielectric material may be formed of HfO₂, HfSiO, HfSiON, HfTaO, HfTiO, HfZrO, ZrO₂, Al₂O₃, or combinations thereof, but embodiments of the present disclosure are not limited thereto. Each of the gate dielectric layers 151 may be formed of a single layer or multiple layers of the above-described materials. In another example embodiment, the gate dielectric layer 151 may include an information storage layer and a dielectric layer. For example, the gate dielectric layer 151 may have polarization characteristics depending on the electric field, and may include a ferroelectric layer that may have remnant polarization due to a dipole even in the absence of an external electric field. Data may be recorded using the polarization state within the ferroelectric layer. Accordingly, the gate dielectric layer 151 may include a ferroelectric layer, which may be referred to as an information storage layer. The ferroelectric layer, which may be the information storage layer, may include Hf-based compounds, Zr-based compounds and/or Hf-Zr-based compounds. For example, the Hf-based compound may be a HfO-based ferroelectric material, the Zr-based compounds may include a ZrO-based ferroelectric material, and the Hf-Zr-based compounds may include a ferroelectric material based on HZO (hafnium zirconium oxide). The ferroelectric layer, which may be the information storage layer, may include a ferroelectric material doped with impurities, such as C, Si, Mg, Al, Y, N, Ge, Sn, Gd, La, Sc and/or Sr. For example, the ferroelectric layer, which may be the information storage layer, may be a material in which HfO₂, ZrO₂ and/or HZrO is doped with impurities, such as C, Si, Mg, Al, Y, N, Ge, Sn, Gd, La, Sc and/or Sr. The information storage layer of the gate dielectric layer 151 is not limited to the above-described material types, and may include materials capable of storing information.

The semiconductor device 100 may further include insulating patterns 130 disposed between the word line structures 150 and the bit line structures 110. The insulating patterns 130 may be in contact with an upper surface of the third conductive pattern 110c of the bit line structure 110, side surfaces of the active patterns 140, and a lower surface of the gate dielectric layer 151 of the word line structures 150. In an example, lower surfaces of the insulating patterns 130 may be disposed on the same level in the vertical direction (Z-direction) as lower surfaces of the active patterns 140. The insulating pattern 130 may include silicon oxide, silicon nitride, silicon oxynitride, silicon carbonitride, low-κ dielectric, or combinations thereof. For example, the insulating pattern 130 may include silicon oxide. In this document, the insulating pattern 130 may be referred to as a gate insulating pattern and may be included in the word line structure 150.

The charge trapping structures 120 are disposed on the bit line structure 110. In an example, the charge trapping structures 120 may intersect the bit line structure 110. The charge trapping structures 120 may extend in the second direction (Y-direction), and may be spaced apart from each other in the first direction (X-direction). In an example, the charge trapping structures 120 may be arranged to alternate with the word line structures 150 in the first direction (X-direction) with the active patterns 140 interposed therebetween. The charge trapping structure 120 may be disposed between two adjacent word line structures 150.

Each of the charge trapping structures 120 may include at least one charge trapping layer 122 and first insulating films 121 between the at least one charge trapping layer 122 and the active patterns 140. The first insulating films 121 and at least one charge trapping layer 122 may extend in the vertical direction (Z-direction). In an example, an upper surface of the charge trapping structure 120 may be disposed on the same level as a level of an upper surface of the word line structure 150 in the vertical (Z-direction). In an example, a lower surface of the charge trapping structure 120 may be disposed on a level lower than a level of the lower surface of the word lines 152, and the upper surface of the charge trapping structure 120 may be disposed on a level higher than a level of upper surfaces of the word lines 152 in the vertical direction (Z-direction). That is, a lower surface of the charge trapping structure 120 may be disposed on the same level as a level of a lower surface of the insulating pattern 130, and the upper surface of the charge trapping structure 120 may be disposed on the same level as a level of an upper surface of the gate capping pattern 160 in the vertical direction (Z-direction).

Electrons formed in a channel region 140a of the active pattern 140 according to a voltage applied to the word lines 152 and a voltage applied to the contact patterns 170 connected to the active patterns 140 may pass through the first insulating film 121 and be trapped in the at least one charge trapping layer 122. The first insulating films 121 may be referred to as a trap insulating layer.

The first insulating films 121 may include a first insulating material, and the at least one charge trapping layer 122 may include a second insulating material different from the first insulating material. In an example, the first insulating films 121 may include oxide, and the at least one charge trapping layer 122 may include nitride. For example, the first insulating films 121 may include silicon oxide (e.g., SiO₂), and the at least one charge trapping layer 122 may include silicon nitride (e.g., Si₃N₄).

Because it is possible to control charges accumulated in the channel region 140a of the active patterns 140 of the cell transistor CTR, for example, holes, a floating body effect may be suppressed or controlled and changes to a threshold voltage of the cell transistor CTR may be prevented or reduced. The charge trapping structure 120 may improve the electrical characteristics of the cell transistor CTR.

The active patterns 140 may be disposed on the bit line structure 110 and may extend in the vertical direction (Z-direction). In a plan view, the active patterns 140 may be disposed between the charge trapping structures 120 and the word line structures 150. The active patterns 140 may be spaced apart from each other in the first direction (X-direction) and the second direction (Y-direction). In an example, upper surface of the active patterns 140 may be disposed on the same level as the upper surface of the charge trapping structure 120 and the upper surface of the word line structure 150 in the vertical direction (Z-direction). A lower surface of the active patterns 140 may be disposed on the same level as a level of the lower surface of the charge trapping structure 120 and a lower surface of the insulating pattern 130 in the vertical direction (Z-direction).

The active patterns 140 may correspond to the channel region and the source/drain regions of the cell transistor CTR illustrated in FIG. 1. In this document, the active patterns 140 may be referred to as 'cell channel structures'.

The active pattern 140 may include a single crystal semiconductor material. The single crystal semiconductor material may include a group IV semiconductor, a group III-V compound semiconductor, or a group II-VI compound semiconductor, and may be, for example, a single crystal semiconductor including silicon, silicon carbide, germanium, and/or silicon-germanium. However, according to example embodiments, the active pattern 140 may include a polycrystalline semiconductor material layer, an oxide semiconductor material layer, such as Indium Gallium Zinc Oxide (IGZO), and/or a two-dimensional material layer such as MoS₂.

An oxide semiconductor layer may be indium gallium zinc oxide (IGZO). However, embodiments of the present disclosure are not limited thereto. For example, the oxide semiconductor layer may include indium tungsten oxide (IWO), indium tin gallium oxide (ITGO), indium aluminum zinc oxide (IAZO), indium gallium oxide (IGO), indium tin zinc oxide (ITZO), zinc tin oxide (ZTO), indium zinc oxide (IZO), ZnO, indium gallium silicon oxide (IGSO), indium oxide (InO), tin oxide (SnO), titanium oxide (TiO), zinc oxynitride (ZnON), magnesium zinc oxide (MgZnO), indium zinc oxide (InZnO), indium gallium zinc oxide (InGaZnO), zirconium indium zinc oxide (ZrInZnO), hafnium indium zinc oxide (HfInZnO), tin indium zinc oxide (SnInZnO), aluminum tin indium zinc oxide (AlSnInZnO), silicon indium zinc oxide (SiInZnO), zinc tin oxide (ZnSnO), aluminum zinc tin oxide (AlZnSnO), gallium zinc tin oxide (GaZnSnO), zirconium zinc tin oxide (ZrZnSnO), and/or indium gallium silicon oxide (InGaSiO).

The two-dimensional material layer may include a Transition Metal Dichalcogenide material layer (TMD material layer), a black phosphorous material layer, and/or a hexagonal Boron-Nitride material layer (hBN material layer), which may have semiconductor properties. For example, the two-dimensional material layer may include BiOSe, Crl, WSe2, MoS2, TaS, WS, SnSe, ReS, β-SnTe, MnO, AsS, P(black), InSe, h-BN, GaSe, GaN, SrTiO, MXene, and/or Janus 2D materials, which may form two-dimensional materials.

The semiconductor device 100 may include a vertical channel transistor formed of active patterns 140, a bit line structure 110 electrically connected to the active patterns 140, and word lines 152 disposed on at least one side of the active patterns 140.

The contact patterns 170 may be disposed on the active patterns 140 and may be electrically connected to the active patterns 140. The contact patterns 170 may electrically connected to the active patterns 140 and the information storage structure 180.

Lower surfaces of the contact patterns 170 are illustrated as being in contact with the active patterns 140 and the gate dielectric layer 151, but according to example embodiments, the lower surfaces of the contact patterns 170 may be also in contact with the gate capping patterns 160.

The contact patterns 170 may include conductive materials, for example, doped single crystal silicon, doped polycrystalline silicon, a metal, conductive metal nitride, a metal-semiconductor compound, conductive metal oxide, conductive graphene, carbon nanotubes, or a combination thereof. In an example embodiment, the contact patterns 170 may include first, second, third, and fourth contact layers 170a, 170b, 170c and 170d sequentially stacked. For example, the first contact layer 170a may include undoped polycrystalline silicon, the second contact layer 170b may include doped polycrystalline silicon, the third contact layer 170c may include a silicide material, and the fourth contact layer 170d may include a metal. However, according to example embodiments, the number of layers and type of material of the contact pattern 170 may vary.

The semiconductor device 100 may further include contact insulation patterns 175 disposed between the first to fourth contact layers 170a to 170d. Each of the contact insulation patterns 175 may extend vertically (in the Z-direction) and may be in contact with the gate capping patterns 160 and/or the charge trapping structure 120. The contact insulation patterns 175 may spatially separate the contact patterns 170 and electrically insulate the contact patterns 170.

The information storage structures 180 may include first electrodes 182 electrically connected to the contact patterns 170, a second electrode 186 on and at least partially covering the first electrodes 182, and a dielectric layer 184 between the first electrodes 182 and the second electrode 186. The information storage structure 180 may correspond to the information storage element DS in the circuit diagram illustrated in FIG. 1.

In an example embodiment, the information storage structures 180 may be capacitors configured to store information in the DRAM. For example, the dielectric layer 184 of the information storage structures 180 may be a capacitor dielectric layer of the DRAM, and the dielectric layer 184 may include the high-κ dielectric, silicon oxide, silicon nitride, silicon oxynitride, or combinations thereof.

According to example embodiments, the information storage structures 180 may be structures configured to store memory information different from the DRAM. For example, the dielectric layer 184 of the information storage structures 180 may be a capacitor dielectric layer of a ferroelectric memory (FeRAM). In this case, the dielectric layer 184 may be a ferroelectric layer that may record data using a polarization state. Regarding the ferroelectric layer, in another example embodiment, the dielectric layer 184 may include a lower dielectric layer including at least one of silicon oxide or high-κ dielectric, and a ferroelectric layer disposed on the lower dielectric layer.

The memory cell array region CELL of the semiconductor device 100 may further include a lower insulating layer 101, interconnection layers 103, vias 105, and first bonding pads BP1, which are disposed below the bit line structure 110. An upper surface of the lower insulating layer 101 may be in contact with a lower surface of the first conductive pattern 110a. The interconnection layers 103 may be buried in the lower insulating layer 101, and may be arranged in a plurality of layers. The vias 105 may electrically connect the interconnection layers 103.

The first bonding pads BP1 may be disposed along a lower surface of the lower insulating layer 101. For example, lower surfaces of the first bonding pads BP1 may be coplanar with lower surfaces of the lower insulating layer 101. Each of the first bonding pads BP1 may be electrically connected to at least one of the interconnection layers 103 and the vias 105. Additionally, the bit line structure 110 may be electrically connected to at least one of the interconnection layers 103 and the vias 105.

The peripheral circuit region PERI of the first structure ST1 may include a device isolating layer 6 and a peripheral transistor TR, which are disposed on an upper surface of the substrate 3. The peripheral transistor TR may include peripheral source/drain regions SD, a peripheral gate dielectric layer GO, and a peripheral gate electrode GE. The peripheral transistor TR may be a planar type transistor. For example, the peripheral source/drain regions SD may be disposed on the upper surface of the substrate 3, and a channel region of the peripheral transistor TR may be disposed between the peripheral source/drain regions SD. The channel region may be coplanar with upper surfaces of the peripheral source/drain regions SD, and may be in contact with a lower surface of the peripheral gate dielectric layer GO. The peripheral transistor TR may be a component of the sub-word line drivers and the sense amplifiers described above.

The first structure ST1 may further include an insulating layer 9, interconnection layers 12, vias 15, and second bonding pads BP2 disposed on the substrate 3. The insulating layer 9 may be on and at least partially cover the upper surface of the substrate 3, and may be on and at least partially cover the peripheral transistor TR. The interconnection layers 12 may be buried within the insulating layer 9, and may be arranged in a plurality of layers. The vias 15 may electrically connect the interconnection layers 12.

The second bonding pads BP2 may be disposed along an upper surface of the insulating layer 9. For example, upper surfaces of the second bonding pads BP2 may be coplanar with the upper surface of the insulating layer 9. Each of the second bonding pads BP2 may be bonded to the first bonding pads BP1 corresponding thereto. Each of the second bonding pads BP2 may be electrically connected to at least one of the interconnection layers 12 and the vias 15. Additionally, the peripheral transistor TR may be electrically connected to at least one of the interconnection layers 12 and the vias 15.

The semiconductor device 100 includes the word line structures 150, the charge trapping structures 120 arranged alternately with the word line structures 150 in the first direction (X-direction), and the active patterns 140 disposed between the word line structures 150 and the charge trapping structures 120. The charge trapping structures 120 may each include first insulating films 121 including a first insulating material, and at least one charge trapping layer 122 adjacent to one side of the active patterns 140 between the first insulating films 121 and including a second insulating material different from the first insulating material. The semiconductor device 100 may adjust a threshold voltage of the semiconductor device as charges in the active patterns 140 pass through the first insulating films 121 and are trapped in at least one charge trapping layer 122, thereby providing the semiconductor device including a vertical channel transistor that ensures versatility and expandability.

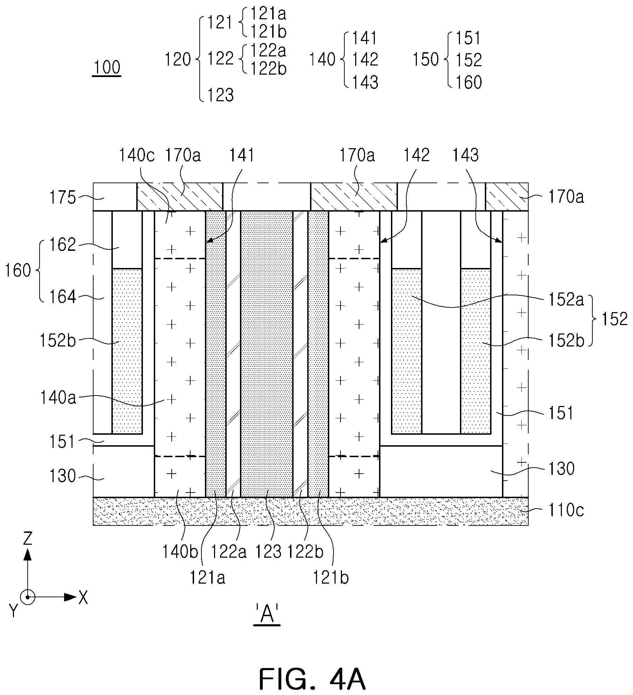

FIG. 4A is an enlarged view of region A of the semiconductor device of FIG. 3 according to an example embodiment.

Referring to FIG. 4A, the semiconductor device 100 includes a charge trapping structure 120, a word line structure 150 spaced apart from the charge trapping structure 120 in the first direction (X-direction), and the active patterns 140 disposed between the charge trapping structure 120 and the word line structure 150.

The active patterns 140 may be spaced apart from each other on a third conductive pattern 110c of a bit line structure 110 in the first direction (X-direction) and the second direction (Y-direction), and may extend in the vertical direction (Z-direction). In an example, each of the activation patterns 140 may include a first source/drain region 140b in contact with the bit line structure 110, a second source/drain region 140c electrically connected to contact patterns 170, and a channel region 140a between the first source/drain region 140b and the second source/drain region 140c. In an example, the first and second source/drain regions 140b and 140c may have an N-type conductivity type.

The active patterns 140 may include first, second and third active patterns 141, 142, and 143 spaced apart from each other in the first direction (X-direction).

The charge trapping structure 120 may be disposed between two adjacent word line structures 150 and may extend between the active patterns 140. In an example, the charge trapping structure 120 may be disposed between the first active pattern 141 and the second active pattern 142. In an example, the charge trapping structure 120 may include at least one charge trapping layer 122, and first insulating films 121 disposed between the first and second active patterns 141 and 142, and the at least one charge trapping layer 122.

The at least one charge trapping layer 122 may include a first charge trapping layer 122a, and a second charge trapping layer 122b spaced apart from the first charge trapping layer 122a in the first direction (X-direction). In an example, the first insulating films 121 may include a 1-1 insulating film 121a disposed between the first active pattern 141 and the first charge trapping layer 122a, and a 1-2 insulating film 121b disposed between the second active pattern 142 and the second charge trapping layer 122b.

The 1-1 insulating film 121a may include a first side surface in contact with the first active pattern 141, and a second side surface opposing the first side surface and in contact with the first charge trapping layer 122a. The 1-2 insulating film 121b may include a third side surface in contact with the second active pattern 142 and a fourth side surface opposing the third side surface and in contact with the second charge trapping layer 122b.

The charge trapping structure 120 may further include a second insulating film 123 disposed between the first charge trapping layer 122a and the second charge trapping layer 122b. The second insulating film 123 may include the same insulating material as a material of the first insulating films 121. However, embodiments of the present disclosure are not limited thereto, and the second insulating film 123 may include an oxide, but may include an oxide that is different from the material of the first insulating films 121.

Widths of each of the first charge trapping layer 122a and the second charge trapping layer 122b in the first direction (X-direction) may be less than widths of each of the 1-1 insulating film 121a and 1-2 insulating film 121b in the first direction (X-direction). For example, the widths of each of the first charge trapping layer 122a and the second charge trapping layer 122b in the first direction (X-direction) may be about 1 to 3 nm. Widths of each of the 1-1 insulating film 121a and the 1-2 insulating film 121b in the first direction (X-direction) may be about 4 to 5 nm.

A width of the second insulating film 123 in the first direction (X-direction) may be greater than the width of each of the first insulating films 121 in the first direction (X-direction) and a width of each of the at least one charge trapping layer 122 in the first direction (X-direction). For example, the width of the second insulating film 123 in the first direction (X-direction) may be about 5 to 10 nm.

The charge trapping structure 120 may include the 1-1 insulating film 121a, the first charge trapping layer 122a, the second insulating film 123, the second charge trapping layer 122b, and the 1-2 insulating film 121b, which are sequentially arranged in the first direction (X-direction).

In this document, the 1-1 insulating film 121a may be referred to as a first insulating pattern, the 1-2 insulating film 121b may be referred to as a second insulating pattern, and the second insulating film 123 may be referred to as a third insulating pattern.

The word lines 152 may be disposed between two adjacent charge trapping structures 120 on the third conductive pattern 110c, and may extend between the second active pattern 142 and the third active pattern 143. In an example, the insulating pattern 130 may be in contact with side surfaces of the second and third active patterns 142 and 143 in contact with the word line structure 150.

The word line structure 150 may include a gate dielectric layer 151, word lines 152, and gate capping patterns 160. The word lines 152 may include first and second word lines 152a and 152b that are disposed between the second active pattern 142 and the third active pattern 143 but are spaced apart from each other in the first direction (X-direction). The first word line 152a may be disposed adjacent to the second active pattern 142, and the second word line 152b may be disposed adjacent to the third active pattern 143. The first and second word lines 152a and 152b may extend in the vertical direction (Z-direction). The first gate capping patterns 162 may be disposed on the first and second word lines 152a and 152b to contact upper surfaces of the first and second word lines 152a and 152b. The second gate capping pattern 164 may extend from a space between the first and second word lines 152a and 152b on the gate dielectric layer 151 to a space between the first gate capping patterns 162. The gate dielectric layer 151 may at least partially surround the first gate capping patterns 162 and the first and second word lines 152a and 152b.

The first contact layers 170a may be disposed on the first, second and third active patterns 141, 142 and 143 and may thus be electrically connected to the first, second and third active patterns 141, 142 and 143. The first contact layers 170a may overlap the first to third active patterns 141 to 143 in the vertical direction (Z-direction), and may overlap a portion of the word line structure 150 and a portion of the charge trapping structure 120 adjacent to the first to third active patterns 141 to 143 in the vertical direction (Z-direction).

The second word line 152b of the word line structure 150 disposed on the left and the first word line 152a of the word line structure 150 disposed on the right based on the charge trapping structure 120 disposed between the first active pattern 141 and the second active pattern 142 may be in the form of sharing one charge trapping structure 120 disposed between the first active pattern 141 and the second active pattern 142.

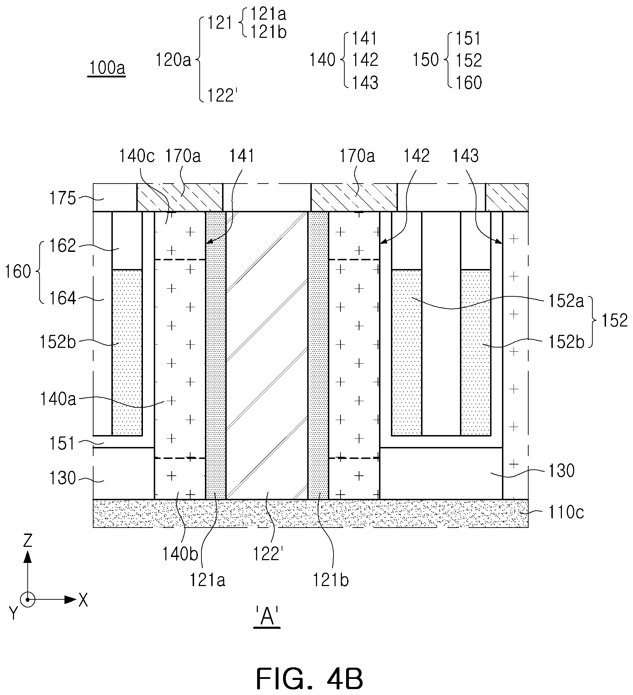

FIG. 4B is an enlarged view of region A of the semiconductor device of FIG. 3 according to another example embodiment.

Referring to FIG. 4B, in a semiconductor device 100a, the remaining components except for the charge trapping structure 120a may be identical to or correspond to the components illustrated in FIG. 4A.

The semiconductor device 100a may include a charge trapping structure 120a, a word line structure 150 spaced apart from the charge trapping structure 120a in the first direction (X-direction), and active patterns 140 disposed between the charge trapping structure 120a and the word line structure 150.

The charge trapping structure 120a may include a charge trapping layer 122' and first insulating films 121 disposed between the first and second active patterns 141 and 142 and the charge trapping layer 122'. The 1-1 insulating film 121a may include a first side surface in contact with the first active pattern 141 and a second side surface opposing the first side surface, and the 1-2 insulating film 121b may include a third side surface in contact with the second active pattern 142 and a fourth side surface opposing the third side surface. The charge trapping layer 122' may be in contact with the second side surface of the 1-1 insulating film 121a and the fourth side surface of the 1-2 insulating film 121b. The first insulating films 121 may include a first insulating material, and the charge trapping layer 122' may include a second insulating material different from the first insulating material. In an example, a width of the charge trapping layer 122' in the first direction (X-direction) may be greater than widths of each of the first insulating films 121 in the first direction (X-direction). For example, the width of the charge trapping layer 122' in the first direction (X-direction) may be about 7 to 16 nm, and the widths of each of the 1-1 insulating film 121a and the 1-2 insulating film 121b in the first direction (X-direction) may be about 4 to 5 nm.

The charge trapping structure 120a may include the 1-1 insulating film 121a, the charge trapping layer 122', and the 1-2 insulating film 121b, which are sequentially arranged in the first direction (X-direction).

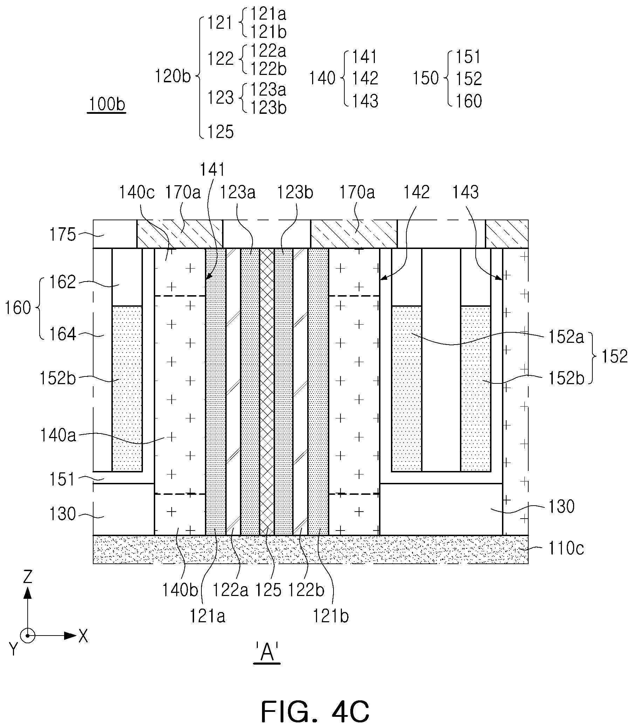

FIG. 4C is an enlarged view of region A of the semiconductor device of FIG. 3 according to another example embodiment.

Referring to FIG. 4C, in a semiconductor device 100b, the remaining components except for the charge trapping structure 120b may be identical to or correspond to the components illustrated in FIG. 4A.

The semiconductor device 100b may include a charge trapping structure 120b, a word line structure 150 spaced apart from the charge trapping structure 120b in the first direction (X-direction), and active patterns 140 disposed between the charge trapping structure 120b and the word line structure 150.

The charge trapping structure 120b may have a structure that further includes a conductive film 125 penetrating or extending through the second insulating film 123 in the charge trapping structure 120 of FIG. 4A. The charge trapping structure 120b may include first and second charge trapping layers 122a and 122b, first insulating films 121 disposed between the first and second active patterns 141 and 142 and the first and second charge trapping layers 122a and 122b, a conductive film 125 disposed between the first and second charge trapping layers 122a and 122b, and a second insulating film 123 in and at least partially filling a space between the first and second charge trapping layers 122a and 122b and the conductive film 125. In an example, the second insulating film 123 may include a 2-1 insulating film 123a disposed between the first charge trapping layer 122a and the conductive film 125, and a 2-2 insulating film 123b disposed between the second charge trapping layer 122b and the conductive film 125.

The conductive film 125 may include doped polysilicon, a metal, conductive metal nitride, a metal-semiconductor compound, conductive metal oxide, graphene, carbon nanotubes, or combinations thereof. For example, the conductive film 125 may include doped polysilicon, Al, Cu, Ti, Ta, Ru, W, Mo, Pt, Ni, Co, TiN, TaN, WN, NbN, TiAl, TiAlN, TiAlC, TaAlC, TiSi, TiSiN, TaSi, TaSiN, RuTiN, NiSi, CoSi, IrOₓ, RuOₓ, graphene, carbon nanotubes, or combinations thereof, but embodiments of the present disclosure are not limited thereto. The conductive film 125 may be formed of a single layer or multiple layers of the above-described materials.

The charge trapping structure 120b may include the 1-1 insulating film 121a, the first charge trapping layer 122a, the 2-1 insulating film 123a, the conductive film 125, the 2-2 insulating film 123b, the second charge trapping layer 122b, and the 1-2 insulating film 121b, which are arranged sequentially in the first direction (X-direction).

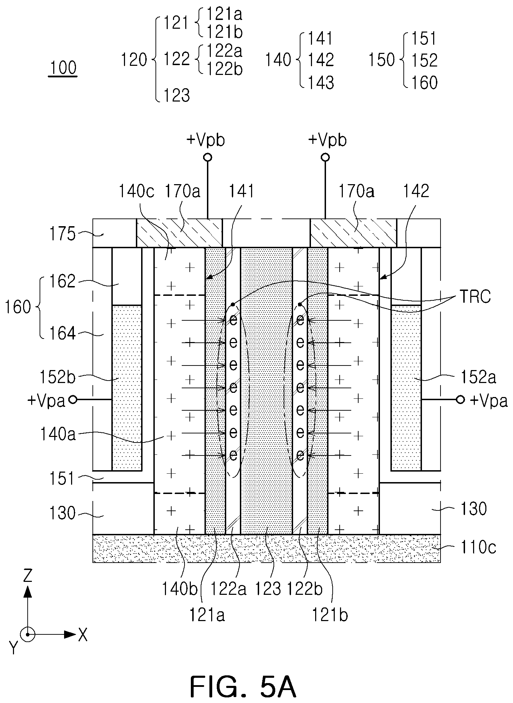

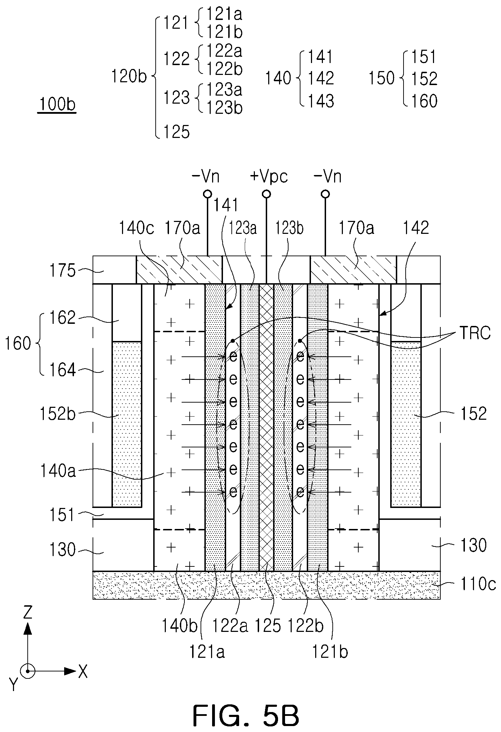

FIG. 5A is a view illustrating an operation of trapping a charge in a charge trapping layer of a charge trapping structure of the semiconductor device of FIG. 4A. FIG. 5B is a diagram illustrating an operation of trapping a charge in a charge trapping layer of a charge trapping structure of the semiconductor device of FIG. 4C.

Referring to FIGS. 5A and 5B, an operation of trapping charges TRC in a charge trapping layer 122 of a charge trapping structure 120 may be a preceding operation (e.g., reading and/or writing) of the semiconductor device 100. For example, the operation of trapping the charges TRC in the charge trapping layer 122 of the charge trapping structure 120 may be an operation firstly performed before program execution when power is supplied to a system of the semiconductor device 100. In another example, an operation of trapping charges in the charge trapping layer 122 of the charge trapping structure 120 may be performed in a final process among manufacturing processes of the semiconductor device 100.

Referring to FIG. 5A, a positive first program voltage (+Vpa) may be applied to word lines 152 to perform an operation to trap the charges TRC in the charge trapping layer 122 of the charge trapping structure 120, and a positive second program voltage (+Vpb) may be applied to a first contact layer 170a (and/or contact patterns 170). The first program voltage (+Vpa) may have a voltage greater than a voltage of a cell transistor (e.g., the threshold voltage of the cell transistor CTR in FIG. 1). The first program voltage (+Vpa) may have a value which may allow electrons in a channel region 140a of an active pattern 140 to pass through first insulating films 121a and 121b and to be trapped in charge trapping layers 122a and 122b.

When a first program voltage (+Vpa) is applied to a second word line 152b disposed on the left of a first active pattern 141, and a second program voltage (+Vpb) is applied to a first contact layer 170a overlapping the first active pattern 141 in the vertical direction (Z-direction), electrons of the channel region 140a of the first active pattern 141 may pass through a 1-1 insulating film 121a in contact with the first active pattern 141 and may be trapped in the first charge trapping layer 122a.

When the first program voltage (+Vpa) is applied to a first word line 152a disposed on the right of a second active pattern 142, and a second program voltage (+Vpb) is applied to a first contact layer 170a overlapping the second active pattern 142 in the vertical direction (Z-direction), electrons of the channel region 140a of the second active pattern 142 may pass through a 1-2 insulating film 121b in contact with the second active pattern 142 and may be trapped in the second charge trapping layer 122b.

In an example embodiment, the operation of trapping the charges TRC in the first charge trapping layer 122a and the operation of trapping the charges TRC in the second charge trapping layer 122b may be performed simultaneously or may be performed independently or separately.

In another example embodiment, when an operation of trapping charges TRC in the charge trapping layer 122' of the charge trapping structure 120a of FIG. 4B is performed, the first program voltage (+Vpa) may be applied to the second word line 152b disposed on the left of the first active pattern 141 and the first word line 152a disposed on the right of the second active pattern 142, and the second program voltage (+Vpb) may be applied to the first contact layer 170a overlapping the first and second active patterns 141 and 142 in the vertical direction (Z-direction). In this case, the electrons of the channel region 140a of the first active pattern 141 may pass through the 1-1 insulating film 121a in contact with the first active pattern 141, and the electrons of the channel region 140a of the second active pattern 142 may pass through the 1-2 insulating film 121b in contact with the second active pattern 142, so that the electrons may be trapped in the charge trapping layer 122'.

Referring to FIGS. 4A, 4B and 5A, the at least one charge trapping layer 122 or 122' may serve as a back gate configured to control charges accumulated in the vertical channel region 140a of the active pattern 140. For example, the vertical channel region 140a in the active pattern may be a floating body disposed between the upper source/drain region 140c and the lower source/drain region 140b, and the at least one charge trapping layer 122 that may function as the back gate may suppress or prevent the performance of the transistor from being degraded due to the floating body effect. For example, the at least one charge trapping layer 122 may reduce, minimize, or prevent a change in the threshold voltage of the transistor by accumulating the charges, for example holes, within the floating body of the vertical channel region 140a.

Referring to FIG. 5B, to perform an operation of trapping charges TRC in a charge trapping layer 122 of a charge trapping structure 120b, a positive third program voltage (+Vpc) may be applied to a conductive film 125, and a negative fourth program voltage (-Vn) may be applied to the first contact layer 170a (and/or the contact patterns 170).

When the fourth program voltage (-Vn) is applied to the first contact layer 170a overlapping the first and second active patterns 141 and 142 in the vertical direction (Z-direction), and the third program voltage (+Vpc) is applied to the conductive film 125, the electrons of the channel region 140a of the first active pattern 141 may pass through the 1-1 insulating film 121a in contact with the first active pattern 141 and may be trapped in the first charge trapping layer 122a, and the electrons of the channel region 140a of the second active pattern 142 may pass through the 1-2 insulating film 121b in contact with the second active pattern 142 and may be trapped in the second charge trapping layer 122b.

In an example embodiment, although not illustrated in the circuit diagram of FIG. 1, a back gate line (not shown) may be formed between the two word lines WL in the circuit diagram of FIG. 1, and the conductive film 125 may correspond to the back gate line.

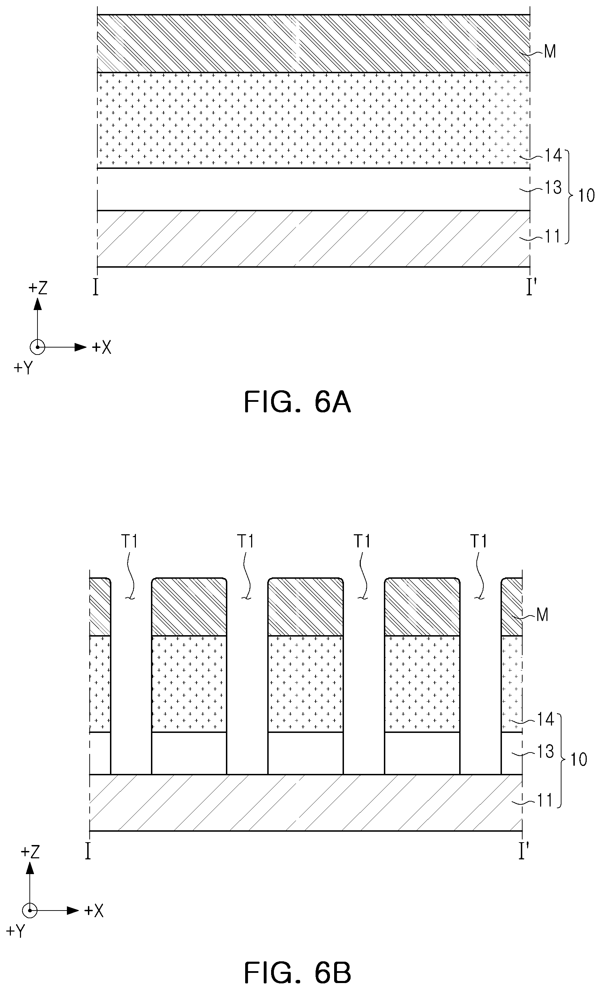

FIGS. 6A to 6I are diagrams illustrating an example embodiment of a method of manufacturing a semiconductor device.

Referring to FIG. 6A, a mask layer M may be formed on a semiconductor substrate 10. In an example embodiment, the semiconductor substrate 10 may be a silicon on insulator (SOI) substrate. The semiconductor substrate 10 may include a lower semiconductor layer 11, an insulating layer 13, and an upper semiconductor layer 14. For example, the lower and upper semiconductor layers 11 and 14 may include single crystal silicon. In some example embodiments, the semiconductor substrate 10 may be a bulk silicon substrate.

Referring to FIG. 6B, first trenches T1 may be formed in the semiconductor substrate 10. The first trenches T1 may vertically (in the Z-direction) penetrate or extend through the mask layer M, the upper semiconductor layer 14 and the insulating layer 13, and may at least partially expose an upper surface of the lower semiconductor layer 11. The first trenches T1 may extend in the second direction (Y-direction) and be spaced apart from each other in the first direction (X-direction).

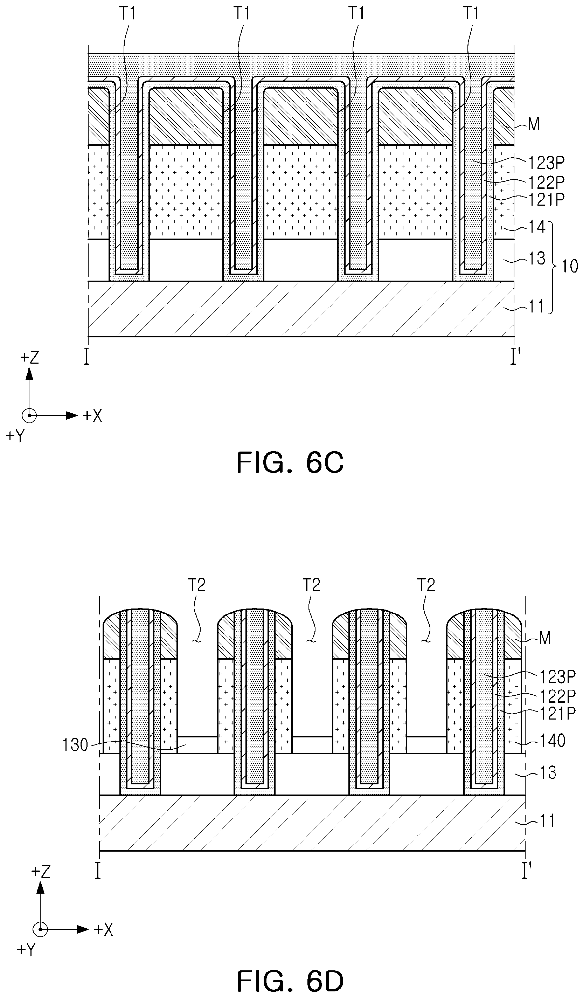

Referring to FIG. 6C, a first material layer 121P, a second material layer 122P, and a third material layer 123P may be sequentially formed conformally along internal walls of the first trenches T1. In an example, the first material layer 121P may be in contact with the mask layer M, the upper semiconductor layer 14, a side surface of the insulating layer 13, and an upper surface of the lower semiconductor layer 11. The second material layer 122P and the third material layer 123P may be sequentially formed on the first material layer 121P according to a surface profile of the first material layer 121P.

The first material layer 121P may include a first insulating material. The second material layer 122P may include a second insulating material different from the first insulating material. The third material layer 123P may include a third insulating material different from the second insulating material. In an example, the first material layer 121P and the third material layer 123P may include oxide, and the second material layer 122P may include nitride. For example, the first material layer 121P and the third material layer 123P include silicon oxide, and the second material layer 122P may include silicon nitride.

The first, second, and third material layers 121P, 122P and 123P may be sequentially deposited by chemical vapor deposition (CVD) or atomic layer deposition (ALD). The first material layer 121P and the third material layer 123P may be deposited to be thicker in the first direction (X-direction) than the second material layer 122P disposed between the first material layer 121P and the third material layer 123P. In an example, the third material layer 123P may be deposited to be thicker in the first direction (X-direction) than the first material layer 121P.

Referring to FIG. 6D, second trenches T2 may be formed in the upper semiconductor layer 14. The second trenches T2 may be formed by anisotropically etching the upper semiconductor layer 14 to expose an upper surface of the insulating layer 13. The second trenches T2 may extend in the second direction (Y-direction) and be spaced apart from each other in the first direction (X-direction). The upper semiconductor layer 14 patterned through the etching process may be referred to as an active pattern 140.

After the etching process, an additional patterning process may be performed on the active patterns 140 in the first direction (X-direction). As illustrated in FIG. 2, the patterned active patterns 140 may be spaced apart from each other in the second direction (Y-direction) along the charge trapping structure 120.

Insulating patterns 130 may be formed between the active patterns 140. The insulating patterns 130 may be in contact with lower regions of the side surfaces of the active patterns 140. The insulating patterns 130 may include silicon oxide, silicon nitride, silicon oxynitride, or combinations thereof. In an example embodiment, the insulating patterns 130 may include silicon oxide.

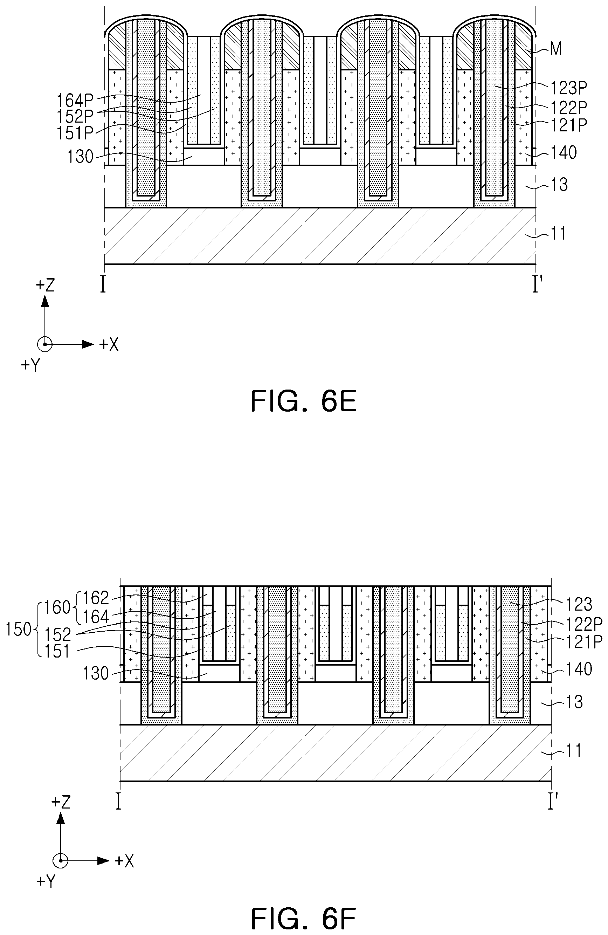

Referring to FIG. 6E, a preliminary dielectric layer 151P may be formed conformally along internal walls of the second trenches T2. The preliminary dielectric layer 151P may be on and at least partially cover a side surface and an upper surface of the mask layer M, upper surfaces of the first, second and third material layers 121P, 122P and 123P, an upper surface of the insulating pattern 130, and a side surface of the active pattern 140.

Preliminary word lines 152P and a preliminary gate capping pattern 164P between the preliminary word lines 152P may be formed on the preliminary dielectric layer 151P within the second trenches T2. The preliminary word lines 152P may be formed by depositing a conductive material on the preliminary dielectric layer 151P, and anisotropically etching the deposited conductive material. The preliminary word lines 152P may extend in the second direction (Y-direction) along the charge trapping structure 120, and may be spaced apart from each other in the first direction (X-direction) (see also the word lines 152 illustrated in FIG. 2).

The preliminary gate capping pattern 164P may be formed between the preliminary word lines 152P on the preliminary dielectric layer 151P within the second trenches T2.

Referring to FIG. 6F, a planarization process may be performed to remove the mask layer M, and a portion of the preliminary word lines 152P and a portion of the preliminary gate capping pattern 164P may be etched through an etch back process. Through the etching process, the preliminary word lines 152P may be formed into word lines 152, and the preliminary gate capping pattern 164P may be formed into the second gate capping pattern 164. First gate capping patterns 162 at least partially surrounded by upper portions of the word lines 152 and the second gate capping pattern 164 may be formed. As the etch back process on the preliminary word lines 152P and the preliminary gate capping pattern 164P is performed and the first gate capping patterns 162 are formed, a word line structure 150 is formed.

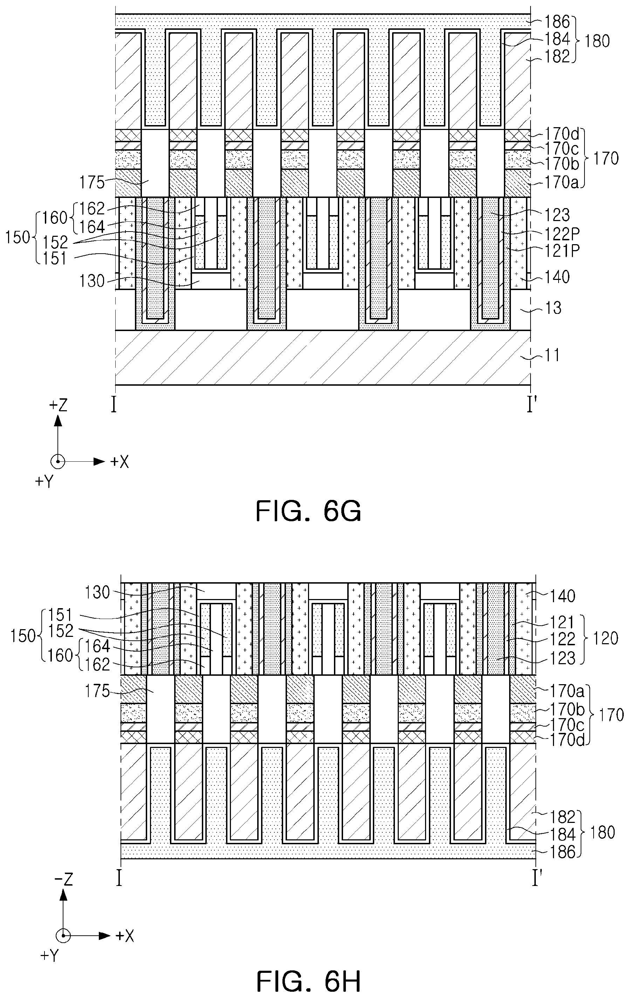

Referring to FIG. 6G, contact patterns 170 may be formed on the active patterns 140. The contact patterns 170 may each include a first contact layer 170a, a second contact layer 170b, a third contact layer 170c and a fourth contact layer 170d, which are sequentially stacked. The contact patterns 170 may be electrically connected to the active patterns 140, respectively.

Contact insulating patterns 175 may be formed between the contact patterns 170. The contact insulating patterns 175 may be formed by sequentially depositing the first to fourth contact layers 170a to 170d and then at least partially filling the contact patterns with an insulating material after a patterning process. The contact insulation patterns 175 may electrically separate the contact patterns 170 from each other.

An information storage structure 180 including first electrodes 182, a dielectric layer 184 and a second electrode 186 may be formed on the contact patterns 170. The first electrodes 182 may be in contact with the fourth contact layers 170d of the contact patterns 170.

Referring to FIG. 6H, a resulting structure of FIG. 6G may be inverted so that the information storage structure 180 faces downward (in the -Z-direction) of the lower semiconductor layer 11 and a grinding process may be performed. The lower semiconductor layer 11 and the insulating layer 13 may be removed by the grinding process, and the insulating pattern 130 and the active pattern 140 may be exposed. In other embodiments, the lower semiconductor layer 11 and the insulating layer 13 may be removed by the grinding process without first inverting the resulting structure of FIG. 6G. The first to third material layers 121P, 122P and 123P may be partially etched to form coplanar surfaces with the active patterns 140. As the first to third material layers 121P, 122P and 123P are partially etched, the charge trapping structure 120 including the first insulating films 121, the charge trapping layers 122 and the second insulating films 123 may be formed.

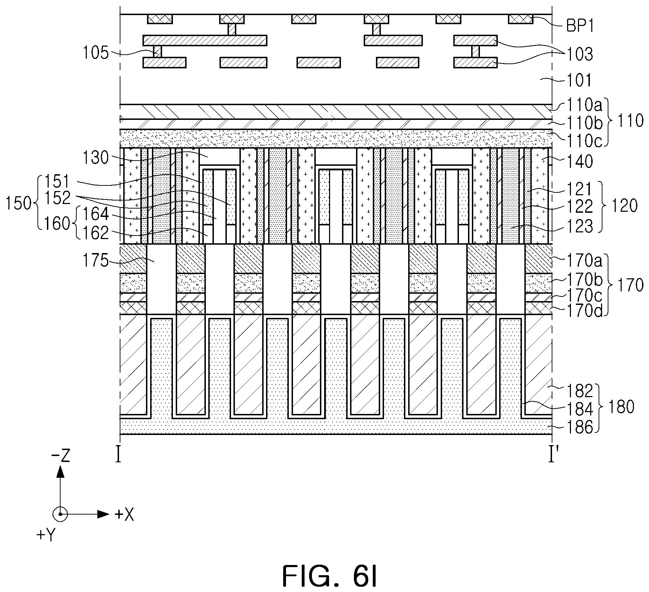

Referring to FIG. 6I, a bit line structure 110 and a lower insulating layer 101 may be formed on the active patterns 140 to manufacture the memory cell array region CELL of the semiconductor device 100 of FIG. 1. The bit line structure 110 may include a third conductive pattern 110c, a second conductive pattern 110b, and a first conductive pattern 110a, which are sequentially stacked on the active patterns 140.

A lower insulating layer 101 may be formed on the bit line structure 110, interconnection layers 103 and vias 105 may be formed in the lower insulating layer 101, and first bonding pads BP1 may be formed on an upper surface (in the -Z-direction) of the lower insulating layer 101.

Next, referring to FIG. 2 together, the memory cell array region CELL (or the second structure ST2 in FIG. 1) may be in contact with the peripheral circuit region PERI (or the first structure ST1 in FIG. 1).

The peripheral circuit region PERI may be formed prior to the formation of the memory cell array region CELL. The peripheral circuit region PERI may be formed prior to the manufacturing process of the cell memory cell array region CELL or may be formed after the manufacturing process of the memory cell array region CELL.

Referring to FIG. 3, on a substrate 3, a peripheral transistor TR on the substrate 3, interconnection layers 12, vias 15, an insulating layer 9 on and at least partially covering the peripheral transistor TR, the interconnection layers 12 and the vias 15, and second bonding pads BP2 are formed, the peripheral circuit region PERI may be manufactured.

The memory cell array region CELL and the peripheral circuit region PERI may be bonded and connected by applying pressure to the first bonding pads BP1 and the second bonding pads BP2. The resulting structure of FIG. 6I may be inverted so that the first bonding pads BP1 of the memory cell array region CELL face downwardly. In an example, the peripheral circuit region PERI and the memory cell array region CELL may be directly bonded without an additional adhesive material or adhesive.

While example embodiments have been illustrated and described above, it will be apparent to those skilled in the art that modifications and variations could be made within a scope as defined by the appended claims.

## Claims

1. A semiconductor device, comprising:
a bit line structure (110);
charge trapping structures (120) on the bit line structure (110);
word line structures (150) arranged alternately with the charge trapping structures (120) in a first direction (X), each of the word line structures (150) including a first word line (152a) and a second word line (152b) spaced apart from each other in the first direction (X);
active patterns (140) arranged on the bit line structure (110), arranged between the charge trapping structures (120) and the word line structures (150), and electrically connected to the bit line structure (110);
contact patterns (170) arranged on the active patterns (140) and electrically connected to the active patterns (140); and
an information storage structure (180) on the contact patterns (170),
wherein each of the charge trapping structures (120) includes:
at least one charge trapping layer (122) between the active patterns (140); and
first insulating films (121) between the at least one charge trapping layer (122) and the active patterns (140).

2. The semiconductor device of claim 1, wherein the first insulating films (121) include a first insulating material, and
wherein the at least one charge trapping layer (122) includes a second insulating material different from the first insulating material.

3. The semiconductor device of claim 2, wherein the first insulating material includes oxide, and
wherein the second insulating material includes nitride.

4. The semiconductor device of any one of claims 1 to 3, wherein the at least one charge trapping layer (122) includes a first charge trapping layer (122a) and a second charge trapping layer (122b) spaced apart from each other in the first direction (X).

5. The semiconductor device of claim 4, wherein widths of each of the first insulating films (121) in the first direction (X) are greater than a width of the first charge trapping layer (122a) and greater than a width of the second charge trapping layer (122b).

6. The semiconductor device of claim 4 or 5, wherein each of the charge trapping structures (120) further includes a second insulating film (123) between the first charge trapping layer (122a) and the second charge trapping layer (122b).

7. The semiconductor device of claim 6, wherein a width of the second insulating film (123) in the first direction (X) is greater than respective widths of each of the first insulating films (121) in the first direction (X).

8. The semiconductor device of claim 4, wherein each of the charge trapping structures (120) further includes a conductive film (125) between the first charge trapping layer (122a) and the second charge trapping layer (122b).

9. The semiconductor device of claim 8, wherein each of the charge trapping structures (120) further includes second insulating films (123a, 123b) between the first charge trapping layer (122a) and the conductive film (125) and between the second charge trapping layer (122b) and the conductive film (125), respectively.

10. The semiconductor device of any one of claims 1 to 9, wherein the at least one charge trapping layer (122) is in contact with the first insulating films (121).

11. The semiconductor device of claim 10, wherein a width of the at least one charge trapping layer (122) in the first direction (X) is greater than widths of each of the first insulating films (121) in the first direction (X), respectively.

12. The semiconductor device of any one of claims 1 to 11, wherein each of the word line structures (150) includes:
a gate insulating pattern (151) between the bit line structure (110) and the first word line (152a) and the second word line (152b);
first gate capping patterns (162) on an upper surface of the first word line (152a) and an upper surface of the second word line (152b); and
a second gate capping pattern (164) arranged on the gate insulating pattern, arranged between the first word line (152a) and the second word line (152b), and arranged between the first gate capping patterns,
wherein an upper surface of the charge trapping structure (120) is coplanar with upper surfaces of the first gate capping patterns (162) and an upper surface of the second gate capping pattern (164).

13. The semiconductor device of any one of claims 1 to 12, further comprising contact insulating patterns between the contact patterns (170),
wherein the contact insulation patterns (175) overlap the charge trapping structure (120) in a second direction (Z), intersecting the first direction (X).

14. The semiconductor device of any one of claims 1 to 13,
wherein the active patterns (140) include first to third active patterns (141, 142, 143) that are arranged in sequence in the first direction (X) on the bit line structure (110),
wherein one of the charge trapping structures (120) is arranged between the first active pattern (141) and the second active pattern (142),
wherein one of the word line structures (150) is arranged between the second active pattern (142) and the third active pattern (143),
wherein the first word line (152a) opposing one side of the second active pattern (142),
wherein the second word line (152b) opposing one side of the third active pattern (143) and spaced apart from the first word line (152a) in the first direction (X), and
wherein the first insulating films (121) includes a first insulating pattern (121a) having a first side surface in contact with the first active pattern (141) and a second side surface opposing the first side surface and including a first insulating material and a second insulating pattern (121b) having a third side surface in contact with the second active pattern (142) and a fourth side surface opposing the third side surface and including the first insulating material.

15. The semiconductor device of claim 14, wherein the at least one charge trapping layer (122) includes a first charge trapping layer (122a) in contact with the second side surface of the first insulating pattern and a second charge trapping layer (122b) in contact with the fourth side surface of the second insulating pattern, and
wherein the one of the charge trapping structures further includes a third insulating pattern including the first insulating material between the first charge trapping layer (122a) and the second charge trapping layer (122b).

## Patentansprüche

1. Eine Halbleitervorrichtung, umfassend:
eine Bitleitungsstruktur (110);
Ladungsspeicherstrukturen (120) auf der Bitleitungsstruktur (110);
Wortleitungsstrukturen (150), die abwechselnd mit den Ladungsspeicherstrukturen (120) in einer ersten Richtung (X) angeordnet sind, wobei jede der Wortleitungsstrukturen (150) eine erste Wortleitung (152a) und eine zweite Wortleitung (152b) umfasst, die in der ersten Richtung (X) voneinander beabstandet sind;
aktive Muster (140), die auf der Bitleitungsstruktur (110) angeordnet sind, zwischen den Ladungsspeicherstrukturen (120) und den Wortleitungsstrukturen (150) angeordnet sind und elektrisch mit der Bitleitungsstruktur (110) verbunden sind;
Kontaktmuster (170), die auf den aktiven Mustern (140) angeordnet und elektrisch mit den aktiven Mustern (140) verbunden sind; und
eine Informationsspeicherstruktur (180) auf den Kontaktmustern (170),
wobei jede der Ladungsspeicherstrukturen (120) umfasst:
mindestens eine Ladungsspeicherschicht (122) zwischen den aktiven Mustern (140); und
erste Isolierfilme (121) zwischen der mindestens einen Ladungsspeicherschicht (122) und den aktiven Mustern (140).

2. Die Halbleitervorrichtung nach Anspruch 1, wobei die ersten Isolierfilme (121) ein erstes Isoliermaterial umfassen, und
wobei die mindestens eine Ladungsspeicherschicht (122) ein zweites Isoliermaterial umfasst, das sich vom ersten Isoliermaterial unterscheidet.

3. Die Halbleitervorrichtung nach Anspruch 2, wobei das erste Isoliermaterial ein Oxid umfasst und
wobei das zweite Isoliermaterial ein Nitrid umfasst.

4. Die Halbleitervorrichtung nach einem der Ansprüche 1 bis 3, wobei die mindestens eine Ladungsspeicherschicht (122) eine erste Ladungsspeicherschicht (122a) und eine zweite Ladungsspeicherschicht (122b) umfasst, die in der ersten Richtung (X) voneinander beabstandet sind.

5. Die Halbleitervorrichtung nach Anspruch 4, wobei die Breiten jedes der ersten Isolierfilme (121) in der ersten Richtung (X) größer sind als die Breite der ersten Ladungsspeicherschicht (122a) und größer als die Breite der zweiten Ladungsspeicherschicht (122b).

6. Die Halbleitervorrichtung nach Anspruch 4 oder 5, wobei jede der Ladungsspeicherstrukturen (120) ferner einen zweiten Isolierfilm (123) zwischen der ersten Ladungsspeicherschicht (122a) und der zweiten Ladungsspeicherschicht (122b) umfasst.

7. Die Halbleitervorrichtung nach Anspruch 6, wobei eine Breite des zweiten Isolierfilms (123) in der ersten Richtung (X) größer ist als die jeweiligen Breiten jedes der ersten Isolierfilme (121) in der ersten Richtung (X).

8. Die Halbleitervorrichtung nach Anspruch 4, wobei jede der Ladungsspeicherstrukturen (120) ferner einen leitfähigen Film (125) zwischen der ersten Ladungsspeicherschicht (122a) und der zweiten Ladungsspeicherschicht (122b) umfasst.

9. Die Halbleitervorrichtung nach Anspruch 8, wobei jede der Ladungsspeicherstrukturen (120) ferner zweite Isolierfilme (123a, 123b) zwischen der ersten Ladungsspeicherschicht (122a) und dem leitfähigen Film (125) bzw. zwischen der zweiten Ladungsspeicherschicht (122b) und dem leitfähigen Film (125) umfasst.

10. Die Halbleitervorrichtung nach einem der Ansprüche 1 bis 9, wobei die mindestens eine Ladungsspeicherschicht (122) mit den ersten Isolierfilmen (121) in Kontakt steht.

11. Die Halbleitervorrichtung nach Anspruch 10, wobei eine Breite der mindestens einen Ladungsspeicherschicht (122) in der ersten Richtung (X) größer ist als die Breiten der ersten Isolierfilme (121) in der ersten Richtung (X).

12. Die Halbleitervorrichtung nach einem der Ansprüche 1 bis 11, wobei jede der Wortleitungsstrukturen (150) umfasst:
ein Gate-Isoliermuster (151) zwischen der Bitleitungsstruktur (110) und der ersten Wortleitung (152a) und der zweiten Wortleitung (152b);
erste Gate-Abdeckmuster (162) auf einer Oberseite der ersten Wortleitung (152a) und einer Oberseite der zweiten Wortleitung (152b); und
ein zweites Gate-Abdeckmuster (164), das auf dem Gate-Isoliermuster angeordnet ist, zwischen der ersten Wortleitung (152a) und der zweiten Wortleitung (152b) angeordnet ist, und zwischen den ersten Gate-Abdeckmustern angeordnet ist,
wobei eine Oberseite der Ladungsspeicherstruktur (120) koplanar mit den Oberseiten der ersten Gate-Abdeckmuster (162) und einer Oberseite des zweiten Gate-Abdeckmusters (164) ist.

13. Die Halbleitervorrichtung nach einem der Ansprüche 1 bis 12, ferner umfassend Kontaktisolationsmuster zwischen den Kontaktmustern (170),
wobei die Kontaktisolationsmuster (175) die Ladungsspeicherstruktur (120) in einer zweiten Richtung (Z) überlappen, die die erste Richtung (X) schneidet.

14. Die Halbleitervorrichtung nach einem der Ansprüche 1 bis 13,
wobei die aktiven Muster (140) erste bis dritte aktive Muster (141, 142, 143) umfassen, die in der ersten Richtung (X) auf der Bitleitungsstruktur (110) angeordnet sind,
wobei eine der Ladungsspeicherstrukturen (120) zwischen dem ersten aktiven Muster (141) und dem zweiten aktiven Muster (142) angeordnet ist,
wobei eine der Wortleitungsstrukturen (150) zwischen dem zweiten aktiven Muster (142) und dem dritten aktiven Muster (143) angeordnet ist,
wobei die erste Wortleitung (152a) einer Seite des zweiten aktiven Musters (142) gegenüberliegt,
wobei die zweite Wortleitung (152b) einer Seite des dritten aktiven Musters (143) gegenüberliegt und in der ersten Richtung (X) von der ersten Wortleitung (152a) beabstandet ist, und
wobei die ersten Isolierfilme (121) ein erstes Isoliermuster (121a) mit einer ersten Seitenfläche, die mit dem ersten aktiven Muster (141) in Kontakt steht, und einer zweiten Seitenfläche, die der ersten Seitenfläche gegenüberliegt und ein erstes Isoliermaterial enthält, und ein zweites Isoliermuster (121b) mit einer dritten Seitenfläche, die mit dem zweiten aktiven Muster (142) in Kontakt steht, und einer vierten Seitenfläche, die der dritten Seitenfläche gegenüberliegt und das erste Isoliermaterial enthält, umfassen.

15. Die Halbleitervorrichtung nach Anspruch 14, wobei die mindestens eine Ladungsspeicherschicht (122) eine erste Ladungsspeicherschicht (122a) in Kontakt mit der zweiten Seitenfläche des ersten Isoliermusters und eine zweite Ladungsspeicherschicht (122b) in Kontakt mit der vierten Seitenfläche des zweiten Isoliermusters umfasst, und
wobei die eine der Ladungsspeicherstrukturen ferner ein drittes Isoliermuster umfasst, welches das erste Isoliermaterial zwischen der ersten Ladungsspeicherschicht (122a) und der zweiten Ladungsspeicherschicht (122b) umfasst.

## Revendications

1. Un dispositif à semi-conducteur, comprenant :
une structure de ligne de bits (110) ;
des structures de piégeage de charge (120) sur la structure de ligne de bits (110) ;
des structures de lignes de mots (150) disposées en alternance avec les structures de piégeage de charge (120) dans une première direction (X), chacune des structures de lignes de mots (150) comprenant une première ligne de mots (152a) et une deuxième ligne de mots (152b) espacées l'une de l'autre dans la première direction (X) ;
des motifs actifs (140) disposés sur la structure de ligne de bits (110), disposés entre les structures de piégeage de charge (120) et les structures de ligne de mots (150), et connectés électriquement à la structure de ligne de bits (110) ;
des motifs de contact (170) disposés sur les motifs actifs (140) et connectés électriquement aux motifs actifs (140) ; et
une structure de stockage d'informations (180) sur les motifs de contact (170),
dans lequel chacune des structures de piégeage de charge (120) comprend :
au moins une couche de piégeage de charge (122) entre les motifs actifs (140) ; et
des premiers films isolants (121) entre la au moins une couche de piégeage de charge (122) et les motifs actifs (140).

2. Le dispositif à semi-conducteur selon la revendication 1, dans lequel les premiers films isolants (121) comprennent un premier matériau isolant, et
dans lequel la au moins une couche de piégeage de charge (122) comprend un deuxième matériau isolant différent du premier matériau isolant.

3. Le dispositif à semi-conducteur selon la revendication 2, dans lequel le premier matériau isolant comprend de l'oxyde, et
dans lequel le deuxième matériau isolant comprend du nitrure.

4. Le dispositif à semi-conducteur selon l'une des revendications 1 à 3, dans lequel la au moins une couche de piégeage de charge (122) comprend une première couche de piégeage de charge (122a) et une deuxième couche de piégeage de charge (122b) espacées l'une de l'autre dans la première direction (X).

5. Le dispositif à semi-conducteur selon la revendication 4, dans lequel les largeurs de chacun des premiers films isolants (121) dans la première direction (X) sont supérieures à la largeur de la première couche de piégeage de charge (122a) et supérieures à la largeur de la deuxième couche de piégeage de charge (122b).

6. Le dispositif à semi-conducteur selon la revendication 4 ou 5, dans lequel chacune des structures de piégeage de charge (120) comprend en outre un deuxième film isolant (123) entre la première couche de piégeage de charge (122a) et la deuxième couche de piégeage de charge (122b).

7. Le dispositif à semi-conducteur selon la revendication 6, dans lequel la largeur du deuxième film isolant (123) dans la première direction (X) est supérieure aux largeurs respectives de chacun des premiers films isolants (121) dans la première direction (X).

8. Le dispositif à semi-conducteur selon la revendication 4, dans lequel chacune des structures de piégeage de charge (120) comprend en outre un film conducteur (125) entre la première couche de piégeage de charge (122a) et la deuxième couche de piégeage de charge (122b).

9. Le dispositif à semi-conducteur selon la revendication 8, dans lequel chacune des structures de piégeage de charge (120) comprend en outre des deuxièmes films isolants (123a, 123b) entre la première couche de piégeage de charge (122a) et le film conducteur (125) et entre la deuxième couche de piégeage de charge (122b) et le film conducteur (125), respectivement.

10. Le dispositif à semi-conducteur selon l'une des revendications 1 à 9, dans lequel la au moins une couche de piégeage de charge (122) est en contact avec les premiers films isolants (121).

11. Le dispositif à semi-conducteur selon la revendication 10, dans lequel la largeur de la au moins une couche de piégeage de charge (122) dans la première direction (X) est supérieure aux largeurs de chacun des premiers films isolants (121) dans la première direction (X), respectivement.

12. Le dispositif à semi-conducteur selon l'une des revendications 1 à 11, dans lequel chacune des structures de ligne de mots (150) comprend :
un motif isolant de grille (151) entre la structure de ligne de bits (110) et la première ligne de mots (152a) et la deuxième ligne de mots (152b) ;
des premiers motifs de recouvrement de grille (162) sur une surface supérieure de la première ligne de mots (152a) et une surface supérieure de la deuxième ligne de mots (152b) ; et
un deuxième motif de recouvrement de grille (164) disposé sur le motif isolant de grille, disposé entre la première ligne de mots (152a) et la deuxième ligne de mots (152b), et disposé entre les premiers motifs de recouvrement de grille,
dans lequel une surface supérieure de la structure de piégeage de charge (120) est coplanaire avec les surfaces supérieures des premiers motifs de recouvrement de grille (162) et une surface supérieure du deuxième motif de recouvrement de grille (164).

13. Le dispositif à semi-conducteur selon l'une des revendications 1 à 12, comprenant en outre des motifs d'isolation de contact entre les motifs de contact (170),
dans lequel les motifs d'isolation de contact (175) chevauchent la structure de piégeage de charge (120) dans une deuxième direction (Z), coupant la première direction (X).

14. Le dispositif à semi-conducteur selon l'une des revendications 1 à 13,
dans lequel les motifs actifs (140) comprennent des premier à troisième motifs actifs (141, 142, 143) qui sont agencés en séquence dans la première direction (X) sur la structure de ligne de bits (110),
dans lequel l'une des structures de piégeage de charge (120) est disposée entre le premier motif actif (141) et le deuxième motif actif (142),
dans lequel l'une des structures de ligne de mots (150) est disposée entre le deuxième motif actif (142) et le troisième motif actif (143),
dans lequel la première ligne de mots (152a) opposée à un côté du deuxième motif actif (142),
dans lequel la deuxième ligne de mots (152b) est opposée à un côté du troisième motif actif (143) et espacée de la première ligne de mots (152a) dans la première direction (X), et
dans lequel les premiers films isolants (121) comprennent un premier motif isolant (121a) ayant une première surface latérale en contact avec le premier motif actif (141) et une deuxième surface latérale opposée à la première surface latérale et comprenant un premier matériau isolant, et un deuxième motif isolant (121b) ayant une troisième surface latérale en contact avec le deuxième motif actif (142) et une quatrième surface latérale opposée à la troisième surface latérale et comprenant le premier matériau isolant.

15. Le dispositif à semi-conducteur selon la revendication 14, dans lequel la au moins une couche de piégeage de charge (122) comprend une première couche de piégeage de charge (122a) en contact avec la deuxième surface latérale du premier motif isolant et une deuxième couche de piégeage de charge (122b) en contact avec la quatrième surface latérale du deuxième motif isolant, et
dans lequel l'une des structures de piégeage de charge comprend en outre un troisième motif isolant comprenant le premier matériau isolant entre la première couche de piégeage de charge (122a) et la deuxième couche de piégeage de charge (122b).
